# FASCICULE DE BREVET EUROPEEN

(11) **EP 0 946 882 B1**
(45) Date de publication et mention de la délivrance du brevet: **29.09.2004**
(21) Numéro de dépôt: 97951319.9
(22) Date de dépôt: 12.12.1997
(51) Int. Cl.: G01R 31/00

(54) **PROCEDE ET DISPOSITIF DE CONTROLE D'UN CIRCUIT ELECTRIQUE DE VEHICULE AUTOMOBILE**
VERFAHREN UND VORRICHTUNG ZUR KONTROLLE EINES ELEKTRISCHEN SCHALTKREISES EINES KRAFTFAHRZEUGS
METHOD AND DEVICE FOR CONTROLLING A MOTOR VEHICLE ELECTRIC CIRCUIT

(30) Priorité: 20.12.1996 FR 9615790
(43) Date de publication de la demande: 06.10.1999
(73) Titulaire: Renault s.a.s., 92100 Boulogne Billancourt (FR)
(72) Inventeur: PUIG, José, F-92400 Courbevoie (FR)
(86) Numéro de dépôt international: PCT/FR1997/002282
(87) Numéro de publication internationale: WO 1998/028629

(56) Documents cités:
- EP-A- 0 450 808
- EP-A- 0 605 997
- FR-A- 2 641 869

## Description

L'invention concerne un procédé et un dispositif de contrôle d'un circuit électrique de véhicule automobile, se présentant sous forme d'un réseau composé de différents organes fonctionnels selon une architecture complexe dont il faut assurer la qualité de réalisation.

Le document FR-A-2 641 869 décrit le contrôle d'un circuit électrique de véhicule automobile comprenant des équipements électriques reliés entre eux par des liaisons électriques par la vérification des tensions d'opération sur les lignes d'alimentation des équipements électriques.

Actuellement, les architectures des réseaux électriques des véhicules sont de plus en plus complexes et les règles d'élaboration des liaisons inter-systèmes, constituées par des alimentations et des masses partagées et par des signaux intercalculateurs, sont de plus en plus difficiles à spécifier. Cependant, il est essentiel d'assurer la qualité de réalisation de ces architectures dans le but, notamment, de réduire les risques d'incendies dans les véhicules dus aux organes électroniques et de garantir aux conducteurs des véhicules des prestations électroniques fiables.
Ainci, la suppression par le conducteur d'un fusible accessible dans l'habitacle, ne doit absolument pas provoquer la destruction d'un calculateur électronique indispensable au contrôle moteur par exemple.

Les procédés de test actuels consistent à réaliser les tests sur le véhicule complet ou sur des bancs de tests électroniques. La détection des défauts de conception des architectures de réseaux se fait par observation du comportement des actionneurs électriques ou des messages électriques incohérents qui transitent entre les différents calculateurs électroniques du véhicule.

Or, cette observation d'un défaut, comme la mise en route anormale d'un actionneur, nécessite la mise en oeuvre de courants suffisamment importants pour que l'effet soit observable. Inversement, une analyse très fine doit parfois être réalisée et nécessite la mise en oeuvre de moyens sophistiqués. C'est le cas particulier de la détection d'une trame logique de communication entre deux calculateurs électroniques, non conforme, qu'il faut décomposer et comparer à la trame attendue. Si certains problèmes peuvent être décelés par ces procédés, tous ne le sont pas en raison du nombre de combinaisons trop important pour ces méthodes manuelles et le principal inconvénient tient au fait que la topologie du périmètre électronique étudié doit être connue, remise en forme et analysée manuellement par rapport à une table de correspondance.

Un autre inconvénient vient de l'impossibilité de considérer le réseau électrique testé comme une simple boîte noire, dont on ne voit que les entrées et les sorties.
Enfin, la complexité de mise en oeuvre et la reproductibilité mal aisée de ces procédés de test empêchent leur utilisation systématique, et rendent difficilement envisageables les tests de non régression.

L'invention vise à résoudre ces inconvénients en proposant un procédé de vérification du bon fonctionnement d'un circuit électrique composé de plusieurs organes fonctionnels, préalablement testés et dont l'assemblage selon une architecture donnée peut présenter des problèmes de fonctionnement.

Un mode de réalisation de l'invention consiste à découper l'architecture électronique du circuit en périmètres d'étude, sachant que, pour un périmètre donné, l'étude de l'influence des organes périphériques à ce périmètre étudié ne nécessite pas la prise en compte desdits circuits périphériques. Puis, on injecte des tensions stabilisées sur certaines liaisons partagées avec plusieurs périmètres, et on lit la déformation, occasionnée par le circuit électrique étudié, dans les liaisons partagées sur lesquelles aucune tension n'a été envoyée. En fonction de la déformation des signaux lus sur ces liaisons, c'est-à-dire de leurs niveaux de tension, des conclusions sont tirées sur la présence ou l'absence de défauts dans l'architecture électronique.

Pour cela, un premier objet de l'invention est un procédé de contrôle d'un circuit électrique de véhicule automobile comprenant plusieurs organes fonctionnels reliés entre eux par des liaisons électriques selon une architecture déterminée, caractérisé en ce qu'il comprend les étapes suivantes :
- découpage de l'architecture électrique du véhicule en périmètres d'étude contenant au moins un organe électrique recevant et émettant du courant électrique ;
- prise en compte des liaisons électriques partagées entre différents périmètres ainsi découpés, constituant des liaisons équipotentielles qui relient au moins deux organes appartenant à des périmètres différents ;
- classification des liaisons électriques partagées en deux catégories, une première catégorie dite des liaisons d'alimentation quand le courant électrique qu'elles véhiculent entre dans le périmètre défini, et une seconde catégorie dite des liaisons de masse quand le courant électrique qu'elles véhiculent sort du périmètre considéré ;
- détection des rebouclages définis comme étant des communications entre deux liaisons d'alimentation ou deux liaisons de masse du périmètre défini.

Selon un autre mode de réalisation de l'invention, pour chaque périmètre d'étude obtenu par découpage du circuit électrique, qui est alimenté par un circuit délivrant une tension continue positive, la détection des rebouclages entre un nombre N de liaisons d'alimentation, N étant un nombre entier supérieur ou égal à 2, consiste à :
- appliquer une tension continue positive de valeur égale à la tension délivrée par le circuit d'alimentation électrique du véhicule, soit 12 volts par exemple, sur au moins une liaison d'alimentation ;
- lire la tension sur chacune des autres liaisons d'alimentation par application d'une tension continue négative, de valeur absolue égale à celle de la tension appliquée sur la première liaison d'alimentation, à travers une résistance d'une valeur telle qu'elle ne perturbe pas le circuit électrique ;
- comparer ladite tension lue sur chacune des autres liaisons d'alimentation à un seuil déterminé ;
- détecter un rebouclage sur une des liaisons d'alimentation quand ladite tension lue est supérieure au seuil.

Selon un autre mode de réalisation de l'invention, la détection des rebouclages entre un nombre M de liaisons de masse, M étant un nombre entier supérieur ou égal à 2, consiste à :
- appliquer une tension de valeur nulle sur au moins une liaison de masse ;
- lire la tension sur les autres liaisons de masse par branchement d'une capacité de valeur prévue pour se décharger rapidement, initialement chargée à une tension déterminée et en série avec une résistance de très faible valeur ;
- comparer ladite tension ainsi lue sur les autres liaisons de masse à un seuil déterminé ;
- détecter un rebouclage entre deux liaisons de masse quand ladite tension lue est inférieure au seuil.

Selon un autre mode de réalisation de l'invention, en cas de détection de rebouclage entre deux liaisons d'alimentation, ou deux liaisons de masse, le procédé de contrôle comporte une étape supplémentaire de mesure du courant maximal capable de transiter par le rebouclage.

D'autres objets de l'invention sont des dispositifs de contrôle selon les revendications 10, 12 et 14 mettant en oeuvre des caractéristiques du procédé précédent.

D'autres modes de réalisation et avantages de l'invention apparaîtront à la lecture de la description, illustrée par les figures suivantes qui sont :
- figure 1 : un exemple de circuit électrique découpé en périmètres d'étude selon l'invention ;
- figures 2 et 3 : un exemple de circuit électrique comprenant deux liaisons d'alimentation à tester ;
- figures 4 et 5 : deux exemples de circuit électrique comprenant deux liaisons de masse à tester;
- figures 6 et 7 : deux exemples de circuit électrique comprenant des liaisons d'alimentation et de masse à tester.

Le procédé de contrôle selon l'invention consiste tout d'abord à découper l'architecture électronique du véhicule en plusieurs périmètres d'étude, comprenant chacun un nombre variable d'organes fonctionnels. Préférentiellement, on testera le périmètre contenant le nombre d'organes le plus faible, un seul par exemple, pour terminer par l'ensemble de l'architecture électrique complète du véhicule, la constitution de chaque périmètre restant libre.

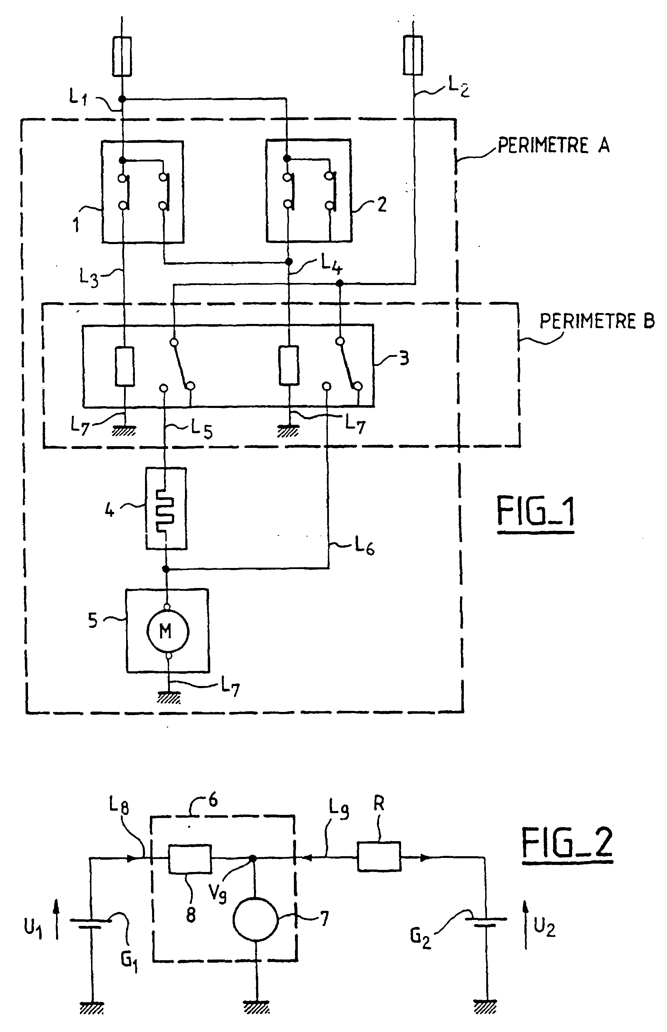

La figure 1 est un exemple particulier non limitatif du circuit électrique comprenant cinq organes 1 à 5 reliés entre eux par des liaisons électriques L₁ à L₇ selon une architecture donnée, et dont le découpage peut engendrer deux périmètres A et B par exemple.
Le périmètre A contient les cinq organes 1 à 5 et le périmètre B contient le seul organe 3.

La deuxième étape du procédé de contrôle consiste à différencier les liaisons électriques internes à chaque périmètre d'étude des liaisons électriques partagées entre au moins deux périmètres et à ne prendre en compte, pour l'analyse, que les liaisons partagées, une liaison partagée étant une équipotentielle qui concerne également des organes ne faisant pas partie du périmètre étudié.
Dans l'exemple de la figure 1, les liaisons qui concernent le périmètre A sont les liaisons référencées L₁ à L₇, les liaisons L₁ et L₂ étant les seules définies comme liaisons partagées entre le périmètre A et d'autres périmètres extérieurs, alors que les liaisons L₃ à L₇ sont définies comme internes au périmètre A. A propos du périmètre B, seule la liaison L₇ reste interne à ce périmètre, tandis que les autres liaisons L₂ à L₆ sont partagées avec le périmètre A.

Une troisième étape du procédé consiste à établir une classification des liaisons électriques partagées en deux catégories selon le sens du courant électrique qu'elles véhiculent. Quand le courant entre dans le périmètre d'étude défini, la liaison est dite d'alimentation, et quand, au contraire, le courant en sort, la liaison est dite de masse.

Le procédé du contrôle consiste ensuite, pour chaque périmètre défini à la suite du découpage du circuit, à détecter les rebouclages qui sont des communications entre deux liaisons d'alimentation ou deux liaisons de masse, par application et lecture de tensions sur les liaisons partagées. Concernant la détection des rebouclages entre plusieurs liaisons d'alimentation, elle comporte tout d'abord l'application d'une tension continue positive, de valeur égale à +12 volts correspondant à la tension d'alimentation délivrée par la batterie du véhicule automobile, sur au moins une liaison d'alimentation, puis la lecture du niveau de la tension apparaissant alors sur chacune des autres liaisons d'alimentation du circuit testé.

Le mode de réalisation le plus favorable pour la détection des rebouclages est celui où on applique la tension continue positive sur une seule liaison d'alimentation, pour lire la tension sur toutes les autres.

La liaison, qui n'aura pas un niveau de tension correct, sera considérée comme défaillante. A cet effet, la lecture de la tension sur ces autres liaisons est réalisée par application, sur chacune d'elles, d'une tension continue négative, de valeur absolue égale à celle de la tension positive appliquée sur la première liaison d'alimentation, soit -12 volts, à travers une résistance de très grande valeur dans le but d'éviter toute perturbation du circuit. Quant à l'intérêt d'appliquer une tension de -12 volts, c'est pour éviter des rebouclages fictifs par ponts de résistances.
Chaque tension lue est ensuite comparée à un seuil déterminé, en fonction de l'organe le plus consommateur de courant, par exemple 2 volts, et un rebouclage est détecté quand cette tension lue est supérieure à ce seuil.
Si le périmètre d'étude du circuit électronique à tester comprend N liaisons d'alimentation, N étant un nombre entier positif supérieur à 2, il faut réaliser cette détection sur chacune des N liaisons, les unes après les autres, afin de vérifier leur bon fonctionnement dans les deux sens pour chacune d'elles.

Selon un mode de réalisation de l'invention, il est aussi prévu de mesurer le courant maximal capable de transiter par un rebouclage détecté. Pour cela, un rebouclage ayant été détecté sur une liaison d'alimentation donnée, on applique à cette dernière une tension nulle, on la relie à la masse, à travers une résistance de très faible valeur afin d'absorber le plus fort courant électrique possible.

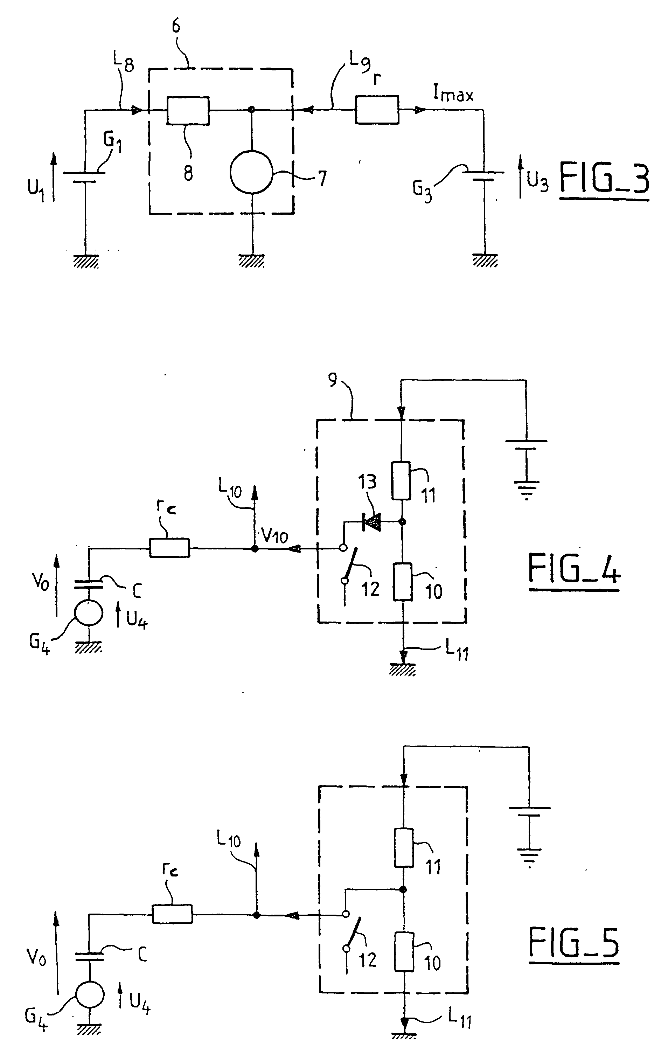

La figure 2 est un exemple d'une partie d'un périmètre 6 de circuit électrique à vérifier, comprenant deux organes 7 et 8 fonctionnels, un moteur et une résistance par exemple, et doux liaisons d'alimentation à tester, L₈ et L₉. Cherchant à tester la liaison L₉ tout d'abord, on applique une tension U₁ de +12 volts sur l'autre liaison L₈ et on mesure la tension V₉ sur la liaison L₉ en lui appliquant une tension U₂ de -12 volts à travers une résistance R, très grande, de l'ordre de 100 mégohms. Si cette tension lue V₉ est supérieure au seuil de 2 volts, on décide qu'il existe un rebouclage entre les deux liaisons d'alimentation L₈ et L₉ et on cherche à mesurer alors le courant maximal Iₘₐₓ, capable de transiter par ce chemin anormal. Dans cette seconde phase, on applique une tension U₃ nulle délivrée par un générateur G₃ à la liaison testée L₉, à travers une résistance r, très faible de l'ordre de 1 milliohm (figure 3).
Il faut ensuite vérifier qu'il n'existe pas de rebouclage entre ces deux mêmes liaisons L₈ et L₉, mais dans l'autre sens, en appliquant sur la liaison L₉ une tension égale à +12 volts et en testant la liaison L₈ par mesure de sa tension selon la même méthode que précédemment. En effet, il peut exister un rebouclage sur une première liaison, avec une seconde liaison dans un sens déterminé et non sur la seconde liaison en provenance de la première.

A propos de la détection, sur chaque périmètre d'étude du circuit, des rebouclages entre un nombre entier positif M de liaisons de masse, M étant par exemple supérieur à deux, la première étape consiste à appliquer une tension de valeur nulle sur une ou plusieurs liaisons de masse, et à contrôler le niveau de la tension apparaissant sur les autres liaisons. Le mode de réalisation le plus favorable pour la détection des rebouclages est celui où on applique la tension nulle sur les (M-1) premières liaisons de masse et on lit la tension sur la dernière liaison.
Cette étape de lecture de la tension sur la Mième et dernière liaison de masse est réalisée par branchement d'une capacité C, dont la valeur est suffisamment faible pour se décharger rapidement, qui est initialement chargée à une tension V₀ déterminée et qui est montée en série avec une résistance de très faible valeur. Ladite tension initiale V₀ est positive pour éviter la détection de problèmes fictifs, et elle est supérieure à 2 volts pour être à l'extérieur des critères de détection.
Pour détecter un rebouclage sur une liaison de masse, il faut comparer la tension lue sur cette liaison à un seuil, par exemple 2 volts, déterminé en fonction de l'organe le plus consommateur de courant, et si cette tension est inférieure à ce seuil, c'est qu'il y a rebouclage.

Selon un mode de réalisation de l'invention, on prévoit également de mesurer le courant maximal pouvant transiter par un rebouclage de masse détecté. A cet effet, on applique, à la liaison de masse sur laquelle il existe un rebouclage, une impulsion de tension positive de valeur égale à la tension d'alimentation du circuit électrique du véhicule, soit 12 volts par exemple, de courte durée, de l'ordre d'une microseconde, et on lit le courant alors généré dans la résistance r_{C} en série avec la capacité C. Pour cela, le dispositif de contrôle, pour la détection des rebouclages sur les liaisons de masse, comporte de plus un quatrième générateur de tension G₄, en série avec la capacité C, délivrant une tension U₄ de valeur nulle pendant la phase de détection d'un rebouclage et une impulsion de tension positive de 12 volts, pendant une microseconde, pour la mesure du courant.

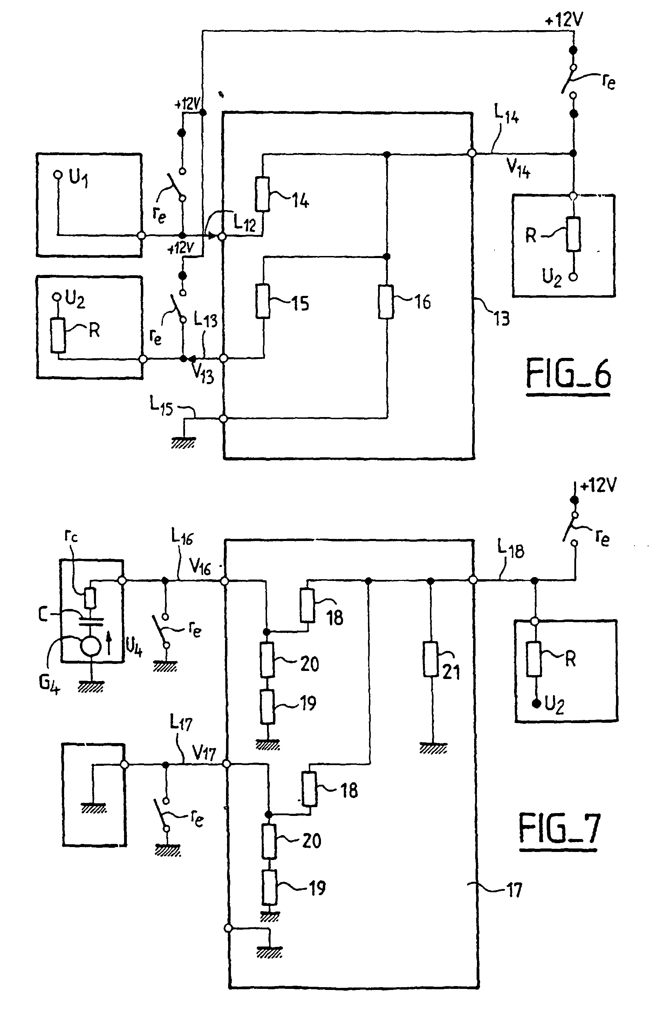

La figure 4 est un exemple d'un périmètre 9 de circuit électrique comprenant des organes fonctionnels 10 à 13 pouvant être par exemple deux résistances 10 et 11, la seconde étant dix fois plus grande que la première, un interrupteur 12 et une diode 13, et deux liaisons de masse L₁₀ et L₁₁ sur lesquelles on veut vérifier l'absence de rebouclage. On commence par relier la liaison L₁₁ à la masse et on teste la liaison L₁₀ en branchant une capacité C entre la masse et cette liaison L₁₀ à travers une résistance r_{C} de faible valeur. La capacité C de valeur voisine de 1 nanoFarad est initialement chargée à une tension V₀ = 3 volts et la résistance r_{C} est de l'ordre de 1 milliohm. La capacité C peut être connectée à un générateur de tension G₄, délivrant une tension U₄ de valeur nulle, au lieu d'être reliée directement à la masse. Si la tension V₁₀ lue sur la liaison L₁₀ est inférieure au seuil fixé, par exemple à 2 volts, après une décharge rapide de la capacité C, c'est qu'il y a un rebouclage de masse sur la liaison L₁₀. Comme la diode est alors bloquée sur le schéma électrique de la figure 4, la tension V₁₀ est supérieure à 3 volts et il n'y a pas rebouclage. Par contre, sur le schéma de la figure 5, dans lequel la diode 13 a été ôtée, il y a détection d'un rebouclage car la tension V₁₀ est inférieure à 2 volts. Pour vérifier si un rebouclage peut se produire sur la liaison de masse L₁₁, on procède de la même façon en inversant le rôle des liaisons.

Un autre objet de l'invention est un dispositif de contrôle mettant en oeuvre le procédé décrit auparavant, comprenant, pour la détection des rebouclages sur les liaisons d'alimentation, un premier générateur G₁ de tension délivrant une première tension U₁ continue positive, de valeur égale à celle de la tension d'alimentation du circuit électrique du véhicule, soit par exemple 12 volts, un deuxième générateur G₂ délivrant une deuxième tension U₂ continue négative, de valeur absolue égale à celle de la première tension, relié à une résistance R, de grande valeur telle que le circuit testé ne soit pas perturbé par le procédé de contrôle, et un troisième générateur G₃ délivrant une troisième tension U₃ de valeur nulle et relié à une résistance r, de faible valeur dont on mesure le courant qui la traverse quand un rebouclage a été détecté sur une liaison.
Pour la détection des rebouclages sur les liaisons de masse, le dispositif utilise le générateur G₄ de tension nulle et comprend de plus une capacité C, destinée à être initialement chargée à une tension de 3 volts par exemple, montée en série avec une résistance r_{c} de faible valeur.
A titre d'exemple non limitatif, les résistances respectives R d'une part, et r et r_{C} d'autre part, ont pour valeurs choisies 100 mégohms, et 1 milliohm, alors que la capacité C a pour valeur 1 nanofarad.

La figure 6 est un exemple d'un périmètre 13 défini dans un calculateur électronique d'injection, à l'intérieur duquel se trouvent deux résistances 14 et 15 de valeur égale à 3, 32 kiloohms et une résistance 16 de valeur 100 kiloomhs, partageant quatre liaisons électriques avec d'autres périmètres. Trois d'entre elles, L₁₂, L₁₃ et L₁₄ sont dites d'alimentation car reliées chacune, par un relais électromagnétique rₑ, à la tension de la batterie du véhicule égale a + 12 volts, et la quatrième L₁₅ correspondant à la masse du calculateur. Pour tester les liaisons d'alimentation L₁₃ et L₁₄, on applique une tension continue positive U₁ de 12 volts sur l'autre liaison d'alimentation L₁₂, et on mesure les tensions V₁₃ et V₁₄ sur les liaisons L₁₃ et L₁₄ en leur appliquait une tension U₂ négative de - 12 volts à travers une résistance R de 100 mégohms. Les tensions V₁₃ et V₁₄ lues sont supérieures à 2 volts, étant données les valeurs des résistances, de sorte qu'il y a rebouclage d'alimentation sur ces deux liaisons.
La figure 7 est un autre exemple d'un périmètre 17 défini dans un calculateur électronique d'injection, comprenant deux séries de trois résistances 18 et 19 de valeur égale à 3,32 kiloohms d'une part, et 20 de valeur égale à 10 kiloohms d'autre part, et une résistance 21 de charge. Deux liaisons de masse L₁₆ et L₁₇, et une liaison d'alimentation L₁₈ ont été définies. Le dispositif de contrôle selon l'invention, appliqué à chaque liaison à tester, permet de détecter un rebouclage de masse sur les liaisons L₁₆ et L₁₇ car les tensions V₁₆ et V₁₇ lues sont comprises entre 0 et 2 volts. Par contre, il n'y pas de rebouclage d'alimentation sur la liaison L₁₈ car la tension V₁₈ est inférieure au seuil de 2 volts.

Un tel dispositif de contrôle peut être simulé analogiquement et donc réalisé sous forme d'un modèle informatique qui présente l'intérêt d'automatiser totalement le procédé de contrôle. Si, de plus, un modèle analogique du véhicule automobile est créé, on pourra alors réaliser les tests du véhicule de manière totalement automatique et par des moyens de simulation analogique. Un avantage de la simulation du dispositif, lors de la mesure de courant en cas de détection de rebouclage de masse, est la possibilité de supprimer automatiquement toutes les capacités présentes à l'intérieur du périmètre étudié qui se comportent comme des court-circuits lors de la mesure du courant.

Etant donné que le procédé selon l'invention consiste notamment à lire des niveaux de tensions sur des liaisons, cela le rend indépendant de la puissance mise en jeu dans le circuit électrique contrôlé et permet une bonne exhaustivité des tests. De plus, le procédé ne dépendant pas du courant, il ne dépend pas de l'observation des phénomènes électriques tels que l'allumage d'une ampoule ou d'un voyant, et autorise une bonne reproductibilité des tests et donc les tests de non régressions.
L'invention permet également de considérer le périmètre d'étude du circuit électrique à tester comme une boîte noire, puisqu'on ne considère que les liaisons partagées avec d'autres périmètres. Il est donc inutile de connaître la topologie des périmètres étudiés. Il est ainsi possible d'élargir le champ des contrôles des architectures électroniques et de s'assurer que les cahiers des charges établis par le constructeur automobile sont bien respectés par les fournisseurs.

## Revendications

1. Procédé de contrôle d'un circuit électrique de véhicule automobile comprenant plusieurs organes fonctionnels reliés entre eux par des liaisons électriques selon une architecture déterminée, **caractérisé en ce qu'**il comprend les étapes suivantes :
- découpage de l'architecture électrique du véhicule en périmètres d'étude contenant au moins un organe électrique traversé par un courant électrique ;
- prise en compte des liaisons électriques partagées entre différents périmètres ainsi découpés, constituant des liaisons équipotentielles ou quasi-équipotentielles qui relient au moins deux organes appartenant à des périmètres différents ;
- classification des liaisons électriques partagées en deux catégories, une première catégorie dite des liaisons d'alimentation quand le courant électrique qu'elles véhiculent entre dans le périmètre défini, et une seconde catégorie dite des liaisons de masse quand le courant électrique qu'elles véhiculent sort du périmètre considéré ;
- détection. des rebouclages définis comme étant des communications entre deux liaisons d'alimentation ou deux liaisons de masse du périmètre défini.

2. Procédé de contrôle selon la revendication 1, **caractérisé en ce que**, pour chaque périmètre d'étude obtenu par découpage du circuit électrique qui est alimenté par un circuit délivrant une tension continue positive, la détection des rebouclages entre un nombre N de liaisons d'alimentation, N étant un nombre entier supérieur ou égal à 2, consiste à :
- appliquer une tension (U₁) continue positive de valeur égale à la tension délivrée par le circuit d'alimentation électrique du véhicule, soit 12 volts par exemple, sur au moins une liaison d'alimentation ;
- lire la tension sur chacune des autres liaisons d'alimentation par application d'une tension (U₂) continue négative, de valeur absolue égale à celle de la tension appliquée sur la première liaison d'alimentation, à travers une résistance d'une valeur telle qu'elle ne perturbe pas le circuit électrique ;
- comparer ladite tension lue sur chacune des autres liaisons d'alimentation à un seuil déterminé ;
- détecter un rebouclage sur une des liaisons d'alimentation quand ladite tension lue est supérieure au seuil.

3. Procédé de contrôle selon la revendication 2, **caractérisé en ce que** l'étape d'application de la tension continue positive, de 12 volts par exemple, se fait sur une première liaison d'alimentation et l'étape suivante de lecture de la tension se fait sur les (N-1) autres liaisons.

4. Procédé de contrôle selon l'une des revendications 2 ou 3, **caractérisé en ce que**, en cas de détection d'un rebouclage entre deux liaisons d'alimentation, le procédé de contrôle comporte une étape supplémentaire de mesure du courant maximal capable de transiter par ledit rebouclage.

5. Procédé de contrôle selon la revendication 4, **caractérisé en ce que** la mesure du courant maximal (Iₘₐₓ) capable de transiter par un rebouclage détecté sur une liaison d'alimentation (L₉) est obtenue par application d'une tension (U₃) de valeur nulle sur ladite liaison, à travers une résistance (r) de très faible valeur afin d'absorber le plus fort courant électrique possible.

6. Procédé de contrôle selon la revendication 1, **caractérisé en ce que** la détection des rebouclages entre un nombre M de liaisons de masse, M étant un nombre entier supérieur ou égal à 2, consiste à :
- appliquer une tension (U₄) de valeur nulle sur au moins une première liaison de masse ;
- lire la tension sur les autres liaisons de masse par branchement d'une capacité de valeur prévue pour se décharger rapidement, initialement chargée à une tension déterminée et en série avec une résistance de très faible valeur ;
- comparer ladite tension ainsi lue sur les autres liaisons de masse à un seuil déterminé ;
- détecter un rebouclage entre deux liaisons de masse quand ladite tension lue est inférieure au seuil.

7. Procédé de contrôle selon la revendication 6, **caractérisé en ce que** l'étape d'application d'une tension nulle se fait sur les (M-1) premières liaisons de masse et l'étape suivante de lecture de tension se fait sur la dernière liaison de masse.

8. Procédé de contrôle selon l'une des revendications 6 ou 7, **caractérisé en ce que**, en cas de détection d'un rebouclage sur une liaison de masse, le procédé de contrôle comporte une étape supplémentaire de mesure du courant maximal capable de transiter par ledit rebouclage.

9. Procédé de contrôle selon la revendication 8, **caractérisé en ce que** la mesure du courant maximal capable de transiter par un rebouclage détecté sur une liaison de masse est obtenue par application d'une impulsion de tension positive, de 12 volts, de courte durée de l'ordre d'une microseconde, suivie d'une lecture du courant généré dans la résistance placée en série avec la capacité.

10. Dispositif de contrôle mettant en oeuvre les étapes du procédé selon les revendications 1, 2 et 3, **caractérisé en ce qu'**il comprend, des moyens pour découper l'architecture électrique du véhicule, des moyens pour classifier les liaisons électriques partagées, des moyens pour détecter des rebouclages sur les liaisons d'alimentation :
- un premier générateur (G₁) de tension délivrant une première tension (U₁) en tant que ladite tension continue positive, à une liaison d'alimentation de valeur égale à la tension délivrée par le circuit d'alimentation électrique du véhicule, soit 12 volts par exemple,
- un deuxième générateur (G₂) délivrant une deuxième tension (U₂) en tant que ladite tension continue négative, de valeur absolue égale à celle de la première tension pour éviter des rebouclages fictifs par ponts de résistance, relié à une résistance (R), de valeur telle que le circuit testé ne soit pas perturbé par le procédé de contrôle,

11. Dispositif de contrôle selon la revendication 10, **caractérisé en ce qu'**il comprend de plus, pour la mesure du courant maximal capable de transiter par un rebouclage sur une liaison d'alimentation, un troisième générateur (G₃) délivrant une troisième tension (U₃) de valeur nulle et relié à une résistance (r), dont on mesure le courant qui la traverse quand un rebouclage a été détecté sur une liaison.

12. Dispositif de contrôle mettant en oeuvre les étapes du procédé selon les revendications 1, 6 et 7, **caractérisé en ce qu'**il comprend de plus, pour la détection des rebouclages sur les liaisons de masse un quatrième générateur (G₄) délivrant une tension (U₄) en tant que ladite tension de valeur nulle et une capacité (C), destinée à être initialement chargée à une tension déterminée, montée en série avec une résistance (r_{C}) sur les liaisons de masse.

13. Dispositif de contrôle selon la revendication 12, **caractérisé en ce que** pour la mesure du courant maximal capable de transiter par un rebouclage sur une liaison de masse, le quatrième générateur (G₄) de tension, placé en série avec la capacité (C) délivre une impulsion de tension positive égale à 12 volts, pendant une microseconde.

14. Dispositif de contrôle **caractérisé en ce que** toutes les caractéristiques techniques du dispositif selon l'une des revendications 10 à 13, sont réalisées sous forme d'un modèle de simulation analogique.

## Claims

1. A method of checking a motor vehicle electrical circuit comprising a plurality of functional members connected together by electrical connections in accordance with a given architecture, **characterised in that** it comprises the following steps:
- cutting up the electrical architecture of the vehicle into study perimeters containing at least one electrical member through which an electric current passes;
- taking into account the electrical connections shared between different perimeters which are cut up **in that** way, constituting equipotential or quasi-equipotential connections which connect at least two members belonging to different perimeters;
- classifying the shared electrical connections in two categories, a first category referred to as supply connections when the electrical current that they carry passes into the defined perimeter and a second category referred to as earth connections when the electrical current that they carry issues from the perimeter in question; and
- detecting the feedbacks defined as being communications between two supply connections or two earth connections of the perimeter defined.

2. A checking method according to claim 1 **characterised in that** for each study perimeter obtained by cutting up the electrical circuit, which is supplied by a circuit delivering a positive dc voltage, detection of the feedbacks between a number N of supply connections, N being an integer greater than or equal to 2, comprises:
- applying a positive dc voltage (U₁) of a value equal to the voltage delivered by the electrical supply circuit of the vehicle, namely 12 volts for example, to at least one supply connection;
- reading the voltage on each of the other supply connections by applying a negative dc voltage (U₂) of an absolute value equal to that of the voltage applied to the first supply connection, through a resistor of a value such that it does not disturb the electrical circuit;
- comparing said voltage read on each of the other supply connections to a given threshold; and
- detecting a feedback on one of the supply connections when said read voltage is greater than the threshold.

3. A checking method according to claim 2 **characterised in that** the step of applying the positive dc voltage of for example 12 volts is effected on a first supply connection and the following step of reading the voltage is effected on the (N-1) other connections.

4. A checking method according to one of claims 2 and 3 **characterised in that** in the case of detecting a feedback between two supply connections the checking method comprises an additional step of measuring the maximum current capable of passing by way of said feedback.

5. A checking method according to claim 4 **characterised in that** measurement of the maximum current (Iₘₐₓ) capable of passing by way of a feedback detected on a supply connection (L₉) is achieved by applying a voltage (U₃ of zero value on said connection by way of a resistor (r) of very low value in order to absorb the greatest possible electric current.

6. A checking method according to claim 1 **characterised in that** detection of the feedbacks between a number M of earth connections, M being an integer greater than or equal to 2, comprises:
- applying a voltage (U₄) of value zero to at least one earth connection;
- reading the voltage on the other earth connections by connecting a capacitor of a value intended to discharge rapidly, initially charged to a given voltage and in series with a resistor of very low value;
- comparing said voltage which is read **in that** way on the other earth connections to a given threshold; and
- detecting a feedback between two earth connections when said read voltage is lower than the threshold.

7. A checking method according to claim 6 **characterised in that** the step of applying a zero voltage is effected on the first (M-1) earth connections and the following voltage reading step is effected on the last earth connection.

8. A checking method according to one of claims 6 and 7 **characterised in that** in the case of detecting a feedback on an earth connection the checking method comprises an additional step of measuring the maximum current capable of passing by way of said feedback.

9. A checking method according to claim 8 **characterised in that** measurement of the maximum current capable of passing by way of a feedback detected on an earth connection is effected by the application of a positive voltage pulse of 12 volts of short duration of the order of a microsecond followed by reading of the current generated in the resistor disposed in series with the capacitor.

10. A checking apparatus for carrying out the steps of the method according to claims 1, 2 and 3 **characterised in that** it comprises means for cutting up the electrical architecture of the vehicle, means for classifying the shared electrical connections, and means for detecting feedbacks on the supply connections:
- a first voltage generator (G₁) delivering a first voltage (U₁) as said positive dc voltage to a supply connection of a value equal to the voltage delivered by the electrical supply circuit of the vehicle, that is to say for example 12 volts,
- a second generator (G₂) delivering a second voltage (U₂) as said negative dc voltage of an absolute value equal to that of the first voltage to avoid fictional feedbacks by way of resistance bridges, connected to a resistor (R) of a value such that the circuit being tested is not disturbed by the checking method.

11. A checking apparatus according to claim 10 **characterised in that** it further comprises, for measuring the maximum current capable of passing by way of a feedback on a supply connection, a third generator (G₃) delivering a third voltage (U₃) of zero value and connected to a resistor (r), in respect of which the current which passes through it when a feedback has been detected on a connection is measured.

12. A checking apparatus for carrying out the steps of the method according to claims 1, 6 and 7 **characterised in that** it further comprises, for detecting feedbacks on the earth connections, a fourth generator (G₄) delivering a voltage (U₄) as said voltage of value zero and a capacitor (C) intended to be initially charged to a given voltage, which is connected in series with a resistor (r_{c}) on the earth connections.

13. A checking apparatus according to claim 12 **characterised in that**, for measuring the maximum current capable of passing by way of a feedback on an earth connection, the fourth voltage generator (G₄) connected in series with the capacitor (C) delivers a positive voltage pulse equal to 12 volts for one microsecond.

14. A checking apparatus **characterised in that** all the technical features of the apparatus according to one of claims 10 to 13 are embodied in the form of an analog simulation model.

## Patentansprüche

1. Verfahren zur Kontrolle einer elektrischen Schaltung Kraftfahrzeugs, welche mehrere funktionelle Einrichtungen umfasst, die untereinander durch elektrische Verbindungen gemäß einer bestimmten Architektur verbunden sind, **dadurch gekennzeichnet, dass** es die folgenden Schritte umfasst:
- Auftrennen der elektrischen Architektur des Fahrzeugs in Untersuchungsbereiche, welche wenigstens eine elektrische Einrichtung enthalten, durch die ein elektrischer Strom passiert;
- Berücksichtigen von geteilten elektrischen Verbindungen zwischen unterschiedlichen so geteilten Bereichen, die äquipotentielle oder quasi-äquipotentielle Verbindungen darstellen, die wenigstens zwei Einrichtungen verbinden, die verschiedenen Bereichen angehören;
- Klassifizieren der geteilten elektrischen Verbindungen in zwei Kategorien, eine erste Kategorie genannt Versorgungsverbindungen, wenn der elektrische Strom, den sie transportierten, in den definierten Bereich eintritt, und eine zweite Kategorie genannt Masseverbindungen, wenn der elektrische Strom, den sie transportieren, aus dem betrachteten Bereich austritt;
- Erkennung von Schleifenverbindungen, die als Kommunikation zwischen zwei Versorgungsverbindungen oder zwei Masseverbindungen des definierten Bereichs definiert werden.

2. Verfahren zur Kontrolle gemäß Anspruch 1, **dadurch gekennzeichnet, dass**, für jeden Untersuchungsbereich, der durch Aufteilen der elektrischen Schaltung erhalten wird, versorgt durch eine Schaltung, die eine positive kontinuierliche Spannung abgibt, die Erkennung von Schleifenverbindung zwischen einer Anzahl N von Versorgungsverbindungen, wobei N eine ganze Zahl größer oder gleich 2 ist, besteht aus:
- Anwenden einer positiven kontinuierlichen Spannung (U₁) vom Wert gleich der Spannung, die von der elektrischen Versorgungsschaltung des Fahrzeugs abgegeben wird, 12V z.B., auf wenigstens eine Versorgungsverbindung;
- Lesen der Spannung auf jeder der anderen Versorgungsverbindungen durch Anwenden einer negativen kontinuierlichen Spannung (U₂), von absolutem Wert gleich dem der auf die erste Versorgungsverbindung angewandten Spannung, über einen Widerstand eines Werts derart, dass er die elektrische Schaltung nicht stört;
- Vergleichen der auf jeder der anderen Versorgungsverbindungen gelesenen Spannungen mit einer bestimmten Schwelle;
- Erkennen einer Schleifenverbindung auf einer der Versorgungsverbindungen, wenn die gelesene Spannung größer als die Schwelle ist.

3. Verfahren zur Kontrolle gemäß Anspruch 2, **dadurch gekennzeichnet, dass** der Schritt der Anwendung der positiven kontinuierlichen Spannung, 12 V z.B., auf einer erste Versorgungsverbindung und der folgende Schritt des Lesens der Spannung für die (N-1) anderen Verbindungen durchgeführt wird.

4. Verfahren zur Kontrolle gemäß Anspruch 2, **dadurch gekennzeichnet, dass**, im Falle der Erkennung einer Schleifenverbindung zwischen zwei Versorgungsverbindungen, das Verfahren zur Kontrolle einen zusätzlichen Schritt des Messens des maximalen Stroms aufweist, der über die Schleifenverbindung passieren kann.

5. Verfahren zur Kontrolle gemäß Anspruch 4, **dadurch gekennzeichnet, dass** das Maß des maximalen Stroms (Iₘₐₓ), der über eine Schleifenverbindung passieren kann, die auf einer Versorgungsverbindung (L₉) erkannt wurde, durch Anwenden einer Spannung (U₃) vom Wert Null auf die Verbindung erhalten wird, über einen Widerstand (r) von sehr geringem Wert, um den größtmöglichen elektrischen Strom zu absorbieren.

6. Verfahren zur Kontrolle gemäß Anspruch 1, **dadurch gekennzeichnet, dass** die Erkennung von Schleifenverbindung zwischen einer Anzahl M von Masseverbindungen, wobei M eine ganze Zahl größer oder gleich 2 ist, besteht aus:
- Anwenden einer Spannung (U₄) vom Wert Null auf wenigstens eine erste Masseverbindung;
- Lesen der Spannung auf den anderen Masseverbindungen durch Koppeln einer Kapazität eines Werts vorgesehen sich schnell zu entladen, ursprünglich geladen auf eine bestimmte Spannung und in Reihe mit einem Widerstand von sehr geringem Wert;
- Vergleichen der so gelesenen Spannung auf den anderen Masseverbindungen mit einer bestimmten Schwelle;
- Erkennen einer Schleifenverbindung zwischen zwei Masseverbindungen, wenn die gelesene Spannung geringer als die Schwelle ist.

7. Verfahren zur Kontrolle gemäß Anspruch 6, **dadurch gekennzeichnet, dass** der Schritt der Anwendung einer Spannung Null für die (M-1) ersten Masseverbindungen und der folgende Schritt des Lesens der Spannung für die letzte Masseverbindung durchgeführt wird.

8. Verfahren zur Kontrolle gemäß einem der Ansprüche 6 oder 7, **dadurch gekennzeichnet, dass**, im Fall der Erkennung einer Schleifenverbindung auf einer Masseverbindung, das Verfahren zur Kontrolle einen zusätzlichen Schritt des Messens des maximalen Stroms aufweist, der über die Schleifenverbindung passieren kann.

9. Verfahren zur Kontrolle gemäß Anspruch 8, **dadurch gekennzeichnet, dass** das Maß des maximalen Stroms, der über eine Schleifenverbindung passieren kann, die auf einer Masseverbindung erkannt wird, durch Anwenden eines Impulses von positiver Spannung erhalten wird, von 12 V, von kurzer Dauer in der Ordnung einer Mikrosekunde, gefolgt von einem Lesen des in dem Widerstand erzeugten Stroms, der in Reihe mit der Kapazität angeordnet ist.

10. Kontrollvorrichtung, welche die Schritte des Verfahrens gemäß den Ansprüchen 1, 2 oder 3 verwirklicht, **dadurch gekennzeichnet, dass** sie Mittel zum Aufteilen der elektrischen Architektur des Fahrzeugs, Mittel zum Klassifizieren der geteilten elektrischen Verbindungen, Mittel zum Erkennen von Schleifenverbindungen auf den Versorgungsleitungen umfasst:
- einen ersten Spannungsgenerator (G₁), der eine erste Spannung (U₁) abgibt, als die positive kontinuierliche Spannung, an eine Versorgungsverbindung mit einem Wert gleich der Spannung, die durch die elektrische Versorgungsschaltung des Fahrzeugs abgegeben wird, 12 V z.B.,
- einen zweiten Generator (G₂), der eine zweite Spannung (U₂) abgibt, als die kontinuierliche Spannung, von einem absoluten Wert gleich dem der ersten Spannung zum Vermeiden von fiktiven Schleifenverbindungen über Widerstandsbrücken, verbunden mit einem Widerstand (R), von einem Wert derart, dass die getestete Schaltung nicht durch das Kontrollverfahren gestört wird.

11. Kontrollvorrichtung gemäß Anspruch 10, **dadurch gekennzeichnet, dass** sie zusätzlich aufweist, für die Messung des maximalen Stroms, der über eine Schleifenverbindung auf einer Versorgungsverbindung passieren kann, einen dritten Generator (G₃), der eine dritte Spannung (U₃) abgibt, vom Wert Null, und verbunden mit einem Widerstand (r), an dem man den Strom misst, der passiert, wenn eine Schleifenverbindung auf einer Verbindung erkannt wurde.

12. Kontrollvorrichtung, welche die Schritte des Verfahrens gemäß den Ansprüchen 1, 6 oder 7 verwirklicht, **dadurch gekennzeichnet, dass** sie zusätzlich aufweist, für die Erkennung von Schleifenverbindung auf den Masseverbindungen, einen vierten Generator (G₄), der eine Spannung (U₄) abgibt, als die Spannung vom Wert Null, und eine Kapazität (C), bestimmt dazu, auf eine bestimmte Spannung ursprünglich geladen zu sein, montiert in Reihe mit einem Widerstand (r_{c}), auf die Masseverbindung.

13. Kontrollvorrichtung gemäß Anspruch 12, **dadurch gekennzeichnet, dass** für das Messen des maximalen Stroms, der über eine Schleifenverbindung auf einer Masseverbindung passieren kann, der vierte Spannungsgenerator (G₄), angeordnet in Reihe mit der Kapazität (C), einen Impuls von positiver Spannung gleich 12 V abgibt während einer Mikrosekunde.

14. Kontrollvorrichtung, **dadurch gekennzeichnet, dass** alle der technischen Eigenschaften der Vorrichtung gemäß einem der Ansprüche 10 bis 13 in Form eines analogen Simulationsmodells verwirklicht werden.
